Europäisches Patentamt

European Patent Office

Office européen des brevets

(11) Veröffentlichungsnummer: **0 262 565**
**A1**

## (12) EUROPÄISCHE PATENTANMELDUNG

(21) Anmeldenummer: 87113866.5

(22) Anmeldetag: 23.09.87

(51) Int. Cl.4: **C03C 8/00** , C03C 10/00 , H05K 1/03

(30) Priorität: 02.10.86 US 914222

(43) Veröffentlichungstag der Anmeldung:
06.04.88 Patentblatt 88/14

(84) Benannte Vertragsstaaten:
AT BE CH DE ES FR GB IT LI NL SE

(71) Anmelder: **MOBAY CORPORATION**
**Patent Department Mobay Road**
**Pittsburgh Pennsylvania 15205-9741(US)**

(72) Erfinder: **Hyde, Robert L.**
**5 Highpasture Court**
**Owings Mills, MD 21117(US)**

(74) Vertreter: **Gremm, Joachim, Dr. et al**
**Bayer AG Konzernverwaltung RP**
**Patentabteilung**
**D-5090 Leverkusen, Bayerwerk(DE)**

(54) **Email-Zusammensetzung und mit dieser beschichtete Substrate.**

(57) Eine partiell entglaste Email-Zusammensetzung wird durch Schmelzen eines Oxid-Gemisches, in dem 20 bis 50 Gew.-% BaO, 30 bis 60 Gew.-% $SiO_2$ und 2 bis 20 Gew.-% $TiO_2$ vorhanden sind, unter Bildung einer homogenen Schmelze gebildet, die Schmelze wird unter Bildung einer Fritte abgeschreckt, und die Fritte gebrannt. Das Oxid-Gemisch kann gegebenenfalls $K_2O$, $Na_2O$, $Li_2O$, $Al_2O_3$, $B_2O_3$, $As_2O_3$, CaO, $CeO_2$, MgO, $F_2$, $N_2O_5$, PbO, $P_2O_5$, $Sb_2O_3$, $SnO_2$, SrO, ZnO, $ZrO_2$ und $MoO_3$ enthalten. Metall-Substrate, die mit einer so zusammengesetzten, partiell entglasten Email beschichtet sind, sind besonders geeignet für die Herstellung elektronischer Schaltungen.

EP 0 262 565 A1

## Email-Zusammensetzung und mit dieser beschichtete Substrate

Die vorliegende Erfindung betrifft eine zur Beschichtung eines Metall-Substrats geeignete Email-Zusammensetzung, mit dieser beschichtete Metall-Substrate und ein Verfahren zur Herstellung solcher beschichteten Substrate.

Bei der Herstellung elektronischer Bauteile unmittelbar auf der Oberfläche eines Substrats werden leitfähige und Widerstandseigenschaften aufweisende, aus Metall-und Glaspulvern zubereitete Druckfarben in Form eines gewünschten Musters auf ein mit einem Isoliermaterial beschichtetes Substrat aufgetragen. Das auf diese Weise bedruckte Bauteil wird dann bei erhöhter Temperatur zum Schmelzen der Materialien in dem Druckfarbstoff und zur Bildung des gewünschten elektronischen Bauteils gebrannt. Die erforderlichen Brenntemperaturen liegen allgemein im Bereich von 600°C bis 900°C.

Im Hinblick auf die Temperaturen, denen das beschichtete Substrat ausgesetzt wird, müssen zur Herstellung elektronischer Bauteile geeignete Substrate fähig sein, hohe Temperaturen auszuhalten, ohne physikalische Veränderungen zu erleiden. Die allgemein eingesetzten Substrate sind Metalle wie Stahl oder Kupfer oder Aluminium. Die Zusammensetzungen, mit denen diese Substrate beschichtet werden, sind im allgemeinen Emails, jedoch variiert die spezielle Zusammensetzung dieser Emails sehr stark.

Es hat sich gezeigt, daß einige dieser Email-Überzüge nicht zufriedenstellend sind, da beim Brennen das Email nicht zu einer Schicht gleichmäßiger Dicke verschmilzt. Dieser Mangel an Gleichmäßigkeit macht es schwierig, die beschichtete Oberfläche genau mit Schaltungen zu bedrucken.

Andere Emails erweichen und fließen wieder, wenn sie dem Nachbrennen unterworfen werden, was eine Verzerrung oder sogar Zerstörung der gedruckten Schaltung zur Folge hat.

Ein anderes größeres Problem, das bei Metall-Substraten, die mit Emails beschichtet sind, auftritt, ist die schlechte Haftung. Dieses Problem der Haftung beruht zum großen Teil auf der beträchtlichen Differenz der thermischen Ausdehnungskoeffizienten des Metall-Substrats und des Email-Überzugs.

Versuche zur Lösung dieser Probleme sind bislang nicht in vollem Umfang erfolgreich verlaufen.

Beispiele für spezielle bekannte Beschichtungsmassen lassen sich in den US-Psen 3 904 423 und 4 256 796 finden.

Ziel der vorliegenden Erfindung war es, eine neue Email-Zusammensetzung zur Verfügung zu stellen, die bei der Herstellung elektronischer Bauteile oder gedruckter Leiterplatten von Nutzen ist.

Ein weiteres Ziel der vorliegenden Erfindung war, eine neue Email-Zusammensetzung verfügbar zu machen, die zu einer Schicht mit gleichmäßiger Dicke verschmilzt, außerdem nicht erweicht, wenn sie dem Nachbrennen unterworfen wird, und einen thermischen Ausdehnungskoeffizienten hat, der demjenigen des Metallkerns, auf den sie aufgetragen wird, nahekommt.

Es war weiterhin ein Ziel der vorliegenden Erfindung, mit Email überzogene Metall-Substrate mit gleichmäßiger Oberfläche und guter Haftung zwischen Metall und Email sowie ein Verfahren zur Herstellung derartiger beschichteter Substrate zur Verfügung zu stellen.

Diese Ziele können dadurch erreicht werden, daß ein Glas mit einer speziellen Oxidzusammensetzung zu einer homogenen Mischung zusammengeschmolzen wird. Die geschmolzene Mischung wird abgeschreckt, und die dabei gebildete Fritte wird in Wasser auf eine feine Teilchengröße vermahlen, wodurch ein Emailschlicker gebildet wird. Ein Metall-Substrat wird mit diesem Schlicker beschichtet und gebrannt.

Die partiell entglasten Email-Zusammensetzungen der vorliegenden Erfindung werden aus wenigstens drei notwendigen Oxiden hergestellt. Diese erforderlichen Oxide sind:

(1) Bariumoxid, das in einer Menge von 20 bis 50 Gew.-%, vorzugsweise von 25 bis 45 Gew.-%, der Gesamt-Zusammensetzung vorhanden ist

(2) Siliciumdioxid, das in einer Menge von 30 bis 60 Gew.-%, vorzugsweise von 35 bis 50 Gew.-%, der Gesamt-Zusammensetzung vorhanden ist, und

(3) Titandioxid, das in einer Menge von 2 bis 20 Gew.-%, vorzugsweise von 4 bis 10 Gew.-%, der Gesamt-Zusammensetzung vorhanden ist.

Bariumoxid, Siliciumdioxid und Titandioxid erzeugen die kristalline Phase der teilweise entglasten Email-Zusammensetzungen der vorliegenden Erfindung. Die bevorzugten Mengen dieser Oxide innerhalb der erforderlichen Bereiche hängen von den erwünschten Werten des Kristallisationsgrades, des Schmelzpunktes der Fritte, der thermischen Ausdehnungskoeffizienten und der Kritallisationsgeschwindigkeit ab.

Als bevorzugte Oxide können wahlweise vorhanden sein:

(4) Kaliumoxid, das in einer Menge von 0 bis 16 Gew.-%, vorzugsweise von 0 bis 12 Gew.-%, der Gesamt-Zusammensetzung vorhanden sein kann,

(5) Zinkoxid, das in einer Menge von 0 bis 7 Gew.-%, vorzugsweise von 0 bis 5 Gew.-%, der Gesamt-Zusammensetzung vorhanden sein kann,

(6) Lithiumoxid, das in einer Menge von 0 bis 4 Gew.-% der Gesamt-Zusammensetzung vorhanden sein kann,

(7) Aluminiumoxid, das in einer Menge von 0 bis 10 Gew.-%, vorzugsweise von 2 bis 8 Gew.-%, der Gesamt-Zusammensetzung vorhanden sein kann,

(8) Magnesiumoxid, das in einer Menge von 0 bis 10 Gew.-%, vorzugsweise von 0 bis 5 Gew.-%, der Gesamt-Zusammensetzung vorhanden sein kann,

(9) Calciumoxid, das in einer Menge von 0 bis 10 Gew.-%, vorzugsweise von -0 bis 5 Gew.-%, der Gesamt-Zusammensetzung vorhanden sein kann,

(10) Strontiumoxid, das in einer Menge von 0 bis 10 Gew.-%, vorzugsweise von 0 bis 5 Gew.-%, der Gesamt-Zusammensetzung vorhanden sein kann,

(11) Zirconiumdioxid, das in einer Menge von 0 bis 10 Gew.-%, vorzugsweise von 0 bis 5 Gew.-%, der Gesamt-Zusammensetzung vorhanden sein kann, und

(12) Natriumoxid in einer Menge von 0 bis 4 Gew.-%, bezogen auf die Gesamt-Zusammensetzung.

Zur Modifizierung der Entglasung, der gebrannten Oberfläche, des Oxidationszustandes oder der thermischen Charakteristik der Zusammensetzung können andere Oxide einbezogen werden:
$As_2O_3$, $B_2O_3$, $CeO_2$, $N_2O_5$, $PbO$, $P_2O_5$, $Sb_2O_3$, $SnO_2$ und $MoO_3$ sowie auf $F_2$.
Keiner dieser Stoffe sollte jedoch in einer Menge von mehr als 3 Gew.-% der Gesamt-Zusammensetzung vorhanden sein.

Mit Lithiumoxid, Natriumoxid und/oder Kaliumoxid kann der Schmelzpunkt der Oxid-Mischung gesteuert werden. Diese Oxide beeinflussen außerdem den Grad der thermischen Ausdehnung der Emails der vorliegenden Erfindung in gewissen Grenzen. Die Kombination dieser Oxide resultiert in einer Email-Zusammensetzung mit besseren elektrischen Eigenschaften als denjenigen die in Zusammensetzungen mit nur einem dieser Oxide vorliegen.

Die anderen oben aufgeführten Oxide können in Mengen innerhalb der angegebenen Bereiche zur Beeinflussung der Kristallisation, der Schmelztemperatur, der Glas-Viskosität und der elektrischen Eigenschaften in bekannter Weise eingesetzt werden.

Die oben aufgeführten Oxide oder Stoffe, die diese Oxide beim Erhitzen bis zur Schmelze bilden (z.B. Magnesiumcarbonat, Bariumcarbonat) werden in den angegebenen Prozentzahlen entsprechenden Gewichtsmengen miteinander vermischt, so daß die Gesamt-Gewichtsmenge etwa dem Wert 100 Gew.-% entspricht. Arbeitstechniken, die die Homogenität der Mischung sicherstellen, und Methoden zur Entfernung etwa vorhandener Feuchtigkeit sind in der Technik bekannt und können vorteilhaft auch bei der Herstellung der Email-Zusammensetzung der vorleigenden Erfindung eingesetzt werden.

Das Gemisch aus Oxiden und/oder Stoffen, die diese Oxide bilden, wird nach herkömmlichen Methoden des Glasschmelzens geschmolzen. Die Mischung wird allmählich auf 1300°C bis 1500°C, vorzugsweise auf 1370°C bis 1470°C, erhitzt, und das erhaltene geschmolzene Material wird auf dieser Temperatur gehalten, bis eine homogene Schmelze erhalten worden ist. Die geeignete Schmelzdauer reicht von 20 min bis zu mehreren Stunden, je nach den verwendeten Geräten, der Menge des geschmolzenen Materials und der speziellen Email-Zusammensetzung.

Die homogene Schmelze wird dann durch Abschrecken in eine Fritte überführt. Verfahren zum Abschrecken einer Schmelze sind ebenfalls in der Technik bekannt. Bei einem solchen Verfahren wird ein Strom des geschmolzenen Glases über einen Satz von in Abständen angeordneten, sich gegenläufig drehenden wassergekühlten Walzen gegossen, wodurch ein dünnes Band aus erstarrtem Glas gewonnen wird. Das erhaltene Glas wird dann zerkleinert. Das zerkleinerte Glas oder die Fritte wird zusammen mit Wasser, Suspendiermitteln und wahlweise Mahlzusätzen in eine Kugelmühle gegeben, worin das Glas oder die Fritte auf eine homogene Korngrößenverteilung vermahlen werden. Teilchengrößen von 5 bis 50 μm, vorzugsweise von 5 bis 25 μm, sind besonders geeignet. Geeignete Suspendiermittel und Mahlzusätze sind aus der Literatur bekannt.

Nach der Entnahme aus der Mühle kann der Emailschlicker zusätzlich mit Wasser versetzt werden. Vorzugsweise wird der Schlicker auf ein spezifisches Gewicht von 1,50 g/cm³ bis 1,80 g/cm³ verdünnt wird. Dieser Schlicker bzw. dieser verdünnte Schlicker wird zum Beschichten des Metall-Substrats verwendet.

Viele Typen von Metallen und Legierungen können mit Email überzogen werden. Kohlenstoffarme Stähle sind jedoch die am häufigsten benutzten Substrate. Nichtrostende legierte Stähle können für besondere Anwendungszwecke überzogen werden. Wenn Aluminium oder ein Material auf Aluminium-Basis beschichtet werden soll, muß das aufzubringende Material eine niedrige Schmelztemperatur haben (d.h. 550°C bis 650°C).

Kohlenstoffarme Stähle sind in der Praxis der vorliegenden Erfindung aus mehreren Gründen die am häufigsten benutzten Substrate. Beispielsweise bildet sich beim Aufbringen eines Email-Decküberzuges in einer Schicht direkt auf einen sehr kohlenstoffarmen Stahl (d.h. ein Stahl mit einem Kohlenstoff-Gehalt von ≤ 0,003 Gew.-%) kein gasförmiges Kohlenstoffdioxid, das Defekte (z.B. Blasen oder Poren) in dem Email-Überzug verursachen kann. Kohlenstoffarme Stähle haben einen thermischen Ausdehnungskoeffizienten von etwa $14 \times 10^{-6}/°C$, der etwa der gleiche ist wie derjenige für die Email-Zusammensetzungen der vorliegenden Erfindung. Andere Legierungstypen mit thermischen Ausdehnungskoeffizienten, die sich von demjenigen kohlenstoffarmer Stähle erheblich unterscheiden, erfordern andere Email-Überzüge mit thermischen Ausdehnungskoeffizienten, die mit denen der spziellen Legierungen nahezu übereinstimmen.

Vor dem Beschichten mit dem Email-Schlicker wird ein geeignetes Metall-Substrat so zugeschnitten, geformt oder gestaltet, daß es die gewünschte Form besitzt.

Viele Methoden zur Beschichtung eines Substrats sind in der Technik bekannt, jedoch ist die elektrophoretische Abscheidung die bevorzugte Methode. Bei dieser Methode wird der Emailschlicker in einen geeigneten Elektrolysebehälter gefüllt. Eine Platte aus Nickel oder aus nichtrostendem Stahl wird als Anode eingesetzt, und das zu beschichtende Substrat wird als Kathode benutzt. Ein elektrischer Strom wird in üblicher Weise durch den Emailschlicker hindurchgeschickt. Die Glas-Teilchen in der Suspension - scheiden sich auf der Oberfläche des Metallgegenstandes ab. Die Dicke des Überzugs hängt von der Konzentration der Teilchen in dem Emailschlicker, der Stromdichte und der Abscheidungsdauer ab. Wenn die gewünschte Dicke der Beschichtung auf dem Metall-Substrat abgeschieden ist, wird das beschichtete Substrat aus dem Emailschlicker entnommen, und man läßt es abtropfen. Das beschichtete Substrat wird kurz gespült und dann bei erhöhter Temperatur (etwa 100°C) getrocknet. Das beschichtete Substrat weist eine gleichmäßige Beschichtung über die gesamte Oberfläche hinweg auf.

Das beschichtete Substrat wird dann direkt in einen Ofen überführt, der auf einer Temperatur von 800°C bis 900°C, vorzugsweise von etwa 900°C, gehalten wird. Die Anfangs-Brenntemperatur muß hinreichend hoch sein, so daß die Beschichtung schmilzt und fast gleichzeitig der Entglasung unterzogen wird. Eine Temperatur von etwa 800°C reicht im allgemeinen aus, jedoch ermöglicht eine Temperatur von etwa 900°C eine raschere Entglasung. Das beschichtete Substrat wird diesen Brennbedingungen solange ausgesetzt, bis die Entglasung im wesentlichen abgeschlossen ist. Die Brenndauer hängt von der Brenntemperatur und der Zusammensetzung der speziellen Beschichtung ab.

Die Beschichtung erleidet während des Brennens eine rasche Veränderung. Wenn die Fritten-Teilchen - schmelzen, beginnt die Rekristallisation, und die Viskosität der Schmelze nimmt schnell zu. Die Entglasung geht während des Brennens rasch vonstatten und hört dann plötzlich auf. Weitere Entglasung findet während des Nachbrennens nicht statt. Der Überzug nimmt ein gleichmäßiges und glattes Aussehen an der Oberfläche an und bekommt nahezu sofort ein mattes Aussehen. Das fertig gebrannte und beschichtete Substrat besitzt einen gleichförmigen Überzug auf der gesamten Oberfläche.

Das gebrannte Email hat eine Schmelztemperatur von über 900°C und enthält die kristalline Phase 2 BaO • TiO₂ • 2 SiO₂. Der gebrannte Überzug enthält sowohl kristallines als auch glasiges Material. Das Verhältnis kristallines Material zu glasigem Material hängt sowohl von der speziellen Fritte als auch von den Brennbedingungen ab.

Das gebrannte Email hat einen hohen thermischen Ausdehnungskoeffizienten (d.h. von 9 bis 15 x $10^{-6}/°C$), der es mit allen Stählen verträglich macht, die gewöhnlich als Substrate verträglich macht, die gewöhnlich als Substrate für das Emaillieren verwendet werden. Es ist diese gute Übereinstimmung der thermischen Ausdehnungskoeffizienten, die die Neigung des überzogenen Substrats zur Rißbildung beim wiederholten Nachbrennen ausschließt oder wesentlich reduziert.

Die überzogenen Substrate der vorliegenden Erfindung sind besonders bei der Herstellung von Bauteilen für Schaltungen von Nutzen. Diese beschichteten Substrate (d.h. Platten für Schaltungen) haben ebene Oberflächen, die leicht und genau bedruckt werden können. Nach dem Bedrucken wird die Platine wiederholt bei Temperaturen von 600°C bis 950°C, vorzugsweise von etwa 900°C, gebrannt, um den Druck in die gewünschten verfahrensin duzierten elektronischen Bauteile zu verschmelzen. Die spezielle Brenntemperatur hängt vom Typ der verwendeten Dickfilm-Druckfarbe ab. Die meisten der gewöhnlich von Fachleuten verwendeten Druckfarben werden bei Temperaturen von 800°C bis 850°C gerannt. Bestimmte Kupfer-Druckfarben erfordern jedoch Brenntemperaturen von 900°C bis 950°C.

Zu den weiteren vorteilhaften Eigenschaften dieser beschichteten Substrate zählen hoher spezifischer elektrischer Widerstand, niedriger dielektrischer Verlust und geringe Wasserlöslichkeit.

Die folgenden Beispiele dienen der näheren Erläuterung der vorliegenden Erfindung, sind jedoch nicht als Beschränkrung des Umfangs der Erfindung aufzufassen. Die Mengen sind in Gew.-% angegeben, sofern nichts anderes vermerkt ist.

4

Beispiel 1

Eine Glasfritte wurde durch Abschrecken einer aus dem folgenden Gemisch von Oxiden homogenen Schmelze in Wasser gebildet:

$K_2O$    13 Gew.-%
BaO    33 Gew.-%
$SiO_2$    37,6 Gew.-%
$Na_2O$    3,3 Gew.-%
$Al_2O_3$    6,0 Gew.-%
$TiO_2$    7,0 Gew.-%
$As_2O_3$    0,1 Gew.-%
$N_2O_5$    1,25 Gew.-5

Die Fritte wurde in Anwesenheit von Wasser und Ton (einem Suspendiermittel) auf eine mittlere Teilchengröße von etwa 25 μm vermahlen, wodurch ein Emailschlicker mit einem Glasfritten-Anteil von etwa 66 % gebildet wurde. Zur Verdünnung dieses Schlickers wurde weiteres Wasser zugesetzt. Der Schlicker wurde dann auf einen extra kohlenstoffarmen Stahl (Kohlenstoff-Gehalt etwa 0,003 Gew.-%) aufgebracht, der gereinigt, mit Schwefelsäure geätzt und vernickelt worden war. Das beschichtete Substrat wurde dann 15 min bei einer Temperatur von 900°C gebrannt. Das gebrannte Substrat hatte einen gleichmäßigen Überzug von 0,13 bis 0,2 mm Dicke. Der Überzug enthielt kristalline Phasen von 2 BaO • $TiO_2$ • 2 $SiO_2$ in erheblichen Mengen, hatte einen thermischen Ausdehnungskoeffizienten von 12,6 x $10^{-6}$/°C (50°C bis 450°C) und einen Erweichungspunkt oberhalb von 925°C.


Beispiele 2 bis 36

Die in Beispiel 1 angewandte Arbeitsweise wurde wiederholt, wobei jeweils die in Tabelle 1 bezeichneten Oxid-Gemische eingesetzt wurden. Die Menge des verwendeten Oxids ist in Gew.-% angegeben. Die Eigenschaften der Überzüge und der beschichteten Substrate, die mit jeder der aus den in Tabelle 1 zusammengefaßten Oxid-Gemischen gebildeten Fritten hergestellt wurden, werden in Tabelle 2 mitgeteilt.

Die Feinheit ist entweder die gemessene Feinheit auf einem Sieb von 0,044 mm (325 mesh) oder die mittlere Teilchengröße. Das spezifische Gewicht, das gemessen wurde, bestimmt die Viskosität und den Grad der Sedimentation der Teilchen in dem Schlicker. Der pH-Wert und die Leitfähigkeit (in μmho) wurden ermittelt und so eingestellt, daß die bestmögliche elektrophoretische Abscheidung erzielt wurde. Die Trübung ist ein Maß für den Grad der Kristallisation. Die Ausdehnung wurde durch Beobachtung bestimmt. Das Absplittern oder Abblättern des Überzugs an den Kanten der Platte zeigt eine zu geringe Ausdehnung des Überzugs an, während das Reißen des Überzugs eine zu starke Ausdehnung anzeigt. Der Erweichungspunkt wird auf der Grundlage von Beobachtungen bestimmt.

T a b e l l e  1

| Bei-spiel Nr. | SiO$_2$ | BaO | TiO$_2$ | K$_2$O | Li$_2$O | Na$_2$O | N$_2$O$_5$ | As$_2$O$_3$ | Al$_2$O$_3$ | MgO | ZnO | ZrO$_2$ | B$_2$O$_3$ | P$_2$O$_5$ | MoO$_3$ |
|---|---|---|---|---|---|---|---|---|---|---|---|---|---|---|---|
| 1 | 37,6 | 33,0 | 7,0 | 13,0 | | 3,3 | 1,25 | 0,1 | 6,0 | | | | | | |
| 2 | 38,0 | 38,8 | 16,2 | 1,5 | | 3,3 | 1,25 | | | | | | 2,2 | | |
| 3 | 46,4 | 33,0 | 8,6 | 9,0 | | 3,0 | 1,25 | | | | | | | | |
| 4 | 36,0 | 30,0 | 7,0 | 11,0 | | 3,0 | 1,25 | | 8,0 | | | 5,0 | | | |
| 5 | 36,0 | 33,0 | 7,0 | 13,0 | | 3,3 | 1,25 | 0,1 | 7,6 | | | | | | |
| 6 | 40,0 | 34,8 | 18,2 | 1,5 | | 3,3 | 1,25 | | | | | | 2,2 | | |
| 7 | 38,9 | 33,0 | 7,0 | 16,0 | | | 1,25 | 0,1 | 5,0 | | | | | | |
| 8 | 43,9 | 33,0 | 7,0 | 16,0 | | | 1,25 | 0,1 | | | | | | | |
| 9 | 38,9 | 33,0 | 7,0 | 15,0 | | | 1,25 | 0,1 | 5,0 | | | | 1,0 | | |
| 10 | 42,4 | 32,0 | 7,0 | 16,0 | | | 1,25 | 0,1 | 2,5 | | | | | | |
| 11 | 37,0 | 50,0 | 10,9 | | 2,0 | | | 0,1 | | | | | | | |
| 12 | 42,0 | 46,2 | 9,7 | | 2,0 | | | 0,1 | | | | | | | |
| 13 | 49,0 | 40,1 | 8,8 | | 2,0 | | | 0,1 | | | | | | | |
| 14 | 43,0 | 42,9 | 9,0 | | 2,0 | | | 0,1 | | | | | | 3,0 | |
| 15 | 37,0 | 46,2 | 9,7 | | 2,0 | | | 0,1 | | | 5,0 | | | | |
| 16 | 44,0 | 42,9 | 11,0 | | 2,0 | | | 0,1 | | | | | | | |
| 17 | 46,0 | 41,1 | 10,8 | | 2,0 | | | 0,1 | | | | | | | |
| 18 | 41,0 | 41,1 | 10,8 | | 2,0 | | | 0,1 | | | | 5,0 | | | |
| 19 | 45,5 | 42,5 | 8,9 | | 3,0 | | | 0,1 | | | | | | | |
| 20 | 47,0 | 24,9 | 7,0 | 16,0 | | | 1,25 | 0,1 | 5,0 | | | | | | |
| 21 | 43,9 | 30,0 | 6,0 | 16,0 | | | 1,25 | 0,1 | 4,0 | | | | | | |
| 22 | 44,4 | 33,0 | 8,5 | 14,0 | | | 1,25 | 0,1 | | | | | | | |

## T a b e l l e 1 (Fortsetzung)

| Bei-spiel Nr. | SiO$_2$ | BaO | TiO$_2$ | K$_2$O | Li$_2$O | Na$_2$O | N$_2$O$_5$ | As$_2$O$_3$ | Al$_2$O$_3$ | MgO | ZnO | ZrO$_2$ | B$_2$O$_3$ | P$_2$O$_5$ | MoO$_3$ |
|---|---|---|---|---|---|---|---|---|---|---|---|---|---|---|---|
| 23 | 44,4 | 30,0 | 8,5 | 14,0 | | | 1,25 | 0,1 | 3,0 | | | | | | |
| 24 | 40,0 | 23,9 | 15,0 | 16,0 | | | 1,25 | 0,1 | 5,0 | | | | | | |
| 25 | 43,0 | 33,9 | 15,0 | 1,0 | 2,0 | | 1,15 | 0,1 | 5,0 | | | | | | |
| 26 | 44,2 | 41,2 | 8,5 | 3,0 | 3,0 | | | 0,1 | | | | | | | |
| 27 | 45,0 | 28,9 | 10,0 | 16,0 | | | 1,25 | 0,1 | | | | | | | |
| 28 | 44,0 | 27,9 | 7,0 | 16,0 | | | 1,25 | 0,1 | | 5,0 | | | | | |
| 29 | 42,0 | 32,0 | 6,9 | 12,0 | 1,0 | | 1,25 | 0,1 | 2,7 | 3,0 | | | | | |
| 30 | 41,7 | 32,0 | 6,9 | 12,0 | 1,0 | | 1,25 | 0,1 | 2,7 | 3,0 | | | | | 0,3 |
| 31 | 43,4 | 40,5 | 8,3 | 4,7 | 3,0 | | | 0,1 | | | | | | | |
| 32 | 40,0 | 33,0 | 6,9 | 15,0 | | | 1,25 | 0,1 | 2,5 | 2,5 | | | | | |
| 33 | 41,5 | 33,0 | 6,9 | 11,5 | 2,0 | | 1,25 | 0,1 | 2,5 | 2,5 | | | | | |
| 34 | 40,5 | 32,0 | 5,9 | 11,5 | 2,0 | | 1,25 | 0,1 | 2,5 | 2,5 | | 3,0 | | | |
| 35 | 41,0 | 33,0 | 6,9 | 11,5 | 2,0 | | 1,25 | 0,1 | 2,5 | 2,5 | | | | | 0,5 |
| 36 | 43,0 | 33,0 | 6,9 | 10,0 | 2,0 | | 1,25 | 0,1 | | 5,0 | | | | | |

0 262 565

## Tabelle 2

| Beispiel Nr. | Feinheit | Spez. Gewicht | pH | Leit- fähig- keit μmho | Stahl Typ[a] | Abschei- dung sek V | | Wärme- behand- lung min °C | | Aussehen d. Ober- fläche | Trübung | Dicke des Über- zugs mm | Relative Aus- dehnung | geschätzt. Erweich- punkt[b] |
|---|---|---|---|---|---|---|---|---|---|---|---|---|---|---|
| 1 | 0,6%/325 | 1,706 | 12,3 | 4850 | CL-ELC | 30 | 40 | 30 | 900 | einwand- frei | hoch | 0,196 | OK | mäßig |
| 2 | 1,0%/325 | 1,708 | 11,7 | 2350 | P-PC | 20 | 40 | 30 | 890 | glatt | hoch | 0,18- 0,20 | niedrig | hoch |
| 3 | 1,0%/325 | 1,697 | 11,8 | 2550 | P-ELC | 30 | 30 | 30 | 900 | glänzend | hoch | 0,20- 0,08 | OK | niedrig |
| 4 | 1,5%/325 | 1,685 | 11,8 | 2700 | P-PC | 25 | 40 | 30 | 900 | rauh | hoch | 0,18 | niedrig | mäßig |
| 5 | 1,2%/325 | ˜1,700 | 12,0 | 2970 | P-PC | 30 | 40 | 30 | 900 | rauh | hoch | 0,18 | OK | mäßig |
| 6 | 1,2%/325 | 1,883 | 12,2 | 3100 | P-PC | 40 | 40 | 30 | 890 | rauh | hoch | 0,14 | niedrig | hoch |
| 7 | 4,2%/325 | ˜1,700 | 12,0 | 2700 | P-PC | 25 | 40 | 15 | 900 | rauh | hoch | 0,23 | OK | mäßig |
| 8 | -- | nur gesprüht | | | ELC | -- | | 15 | 900 | -- | niedrig | -- | OK | |
| 9 | 1,8%/325 | 1,680 | 11,7 | 2700 | P-PC | 20 | 40 | 15 | 900 | rauh/ reißend | hoch | 0,18 | OK | hoch |
| 10 | -- | nur gesprüht | | | ELC | -- | | 15 | 900 | -- | niedrig | -- | OK | |
| 11 | | | | | | | | | | | hoch | | | hoch* |
| 12 | | | | | | | | | | | hoch | | | hoch* |
| 13 | | | | | | | | | | | hoch | | | hoch* |
| 14 | | | | | | | | | | | hoch | | | hoch* |
| 15 | | | | | | | | | | | hoch | | | hoch* |
| 16 | | | | | | | | | | | hoch | | | hoch* |
| 17 | | | | | | | | | | | hoch | | | hoch* |
| 18 | | | | | | | | | | | hoch | | | hoch* |

| Bei-spiel Nr. | Feinheit | Spez. Ge-wicht | Schlicker pH | Leit-fähig-keit µmho | Stahl Typ[a] | Abschei-dung sek V | | Wärme-behand-lung min °C | | Aussehen d. Ober-fläche | Trübung | Dicke des Über zugs mm | Relative Aus-dehnung | geschätzt. Erweich-punkt[b] |
|---|---|---|---|---|---|---|---|---|---|---|---|---|---|---|
| 19 | 12 µm | 1,690 | 11,8 | 2480 | P-ELC | 20 | 40 | 15 | 900 | rauh/reißend | hoch | 0,15-0,18 | etw.niedr. | hoch |
| 20 | | | | | | | | | | | | | | ** |
| 21 | -- | | nur gesprüht | | ELC | | | 15 | 900 | | mäßig | -- | OK | |
| 22 | -- | | nur gesprüht | | ELC | | | 15 | 900 | | niedrig | | niedrig | |
| 23 | -- | | nur gesprüht | | ELC | | | 15 | 900 | | mäßig | | niedrig | |
| 24 | 12 µm | 1,615 | 12,1 | 3170 | P-ELC | 30 | 40 | 15 | 900 | glatt | mäßig | 0,16 | niedrig | mäßig |
| 25 | | | | | | | | | | | hoch | | niedrig | * |
| 26 | | | | | | | | | | | hoch | | niedrig | * |
| 27 | | | | | | | | | | | niedrig | | | |
| 28 | | | | | | | | | | | niedrig | | | |
| 29 | 12 µm | 1,692 | 12,0 | 2160 | P-PC | 20 | 50 | 15 | 900 | glänz./uneben | hoch | 0,15 | hoch | mäßig |
| 30 | 0,8%/325 | 1,752 | 12,0 | 2100 | P-CM-PC | 25 | 50 | 10 | 900 | einwand-frei-gut | hoch | 0,15 | hoch | mäßig |
| 31 | 4%/325 | 1,717 | 11,4 | 2380 | P-PC | 20 | 40 | 5 | 900 | glänz./rauh | mäßig | 0,14 | niedrig | mäßig |
| 32 | 12 µm | 1,619 | 12,1 | 3780 | P-PC | 20 | 40 | 10 | 900 | glatt/reißend | hoch | 0,15-0,18 | OK | mäßig |

0 262 565

Tabelle 2 (Fortsetzung)

| Bei-spiel Nr. | Feinheit | Spez. Ge-wicht | Schlicker pH | Schlicker Leit-fähig-keit µmho | Stahl Typ[a] | Abschei-dung sek | Abschei-dung V | Wärme-behand-lung min | Wärme-behand-lung °C | Aussehen d. Ober-fläche | Trübung | Dicke des Über zugs mm | Relative Aus-dehnung | geschätzt. Erweich-punkt[b] |
|---|---|---|---|---|---|---|---|---|---|---|---|---|---|---|
| 33 | 0,8%/325 | 1,664 | 11,9 | 2010 | P-CM-PC | 20 | 50 | 10 | 900 | fehler-haft | hoch | 0,18 | OK | mäßig |
| 34 | 1%/325 | 1,680 | 12,3 | 3140 | P-ELC | 20 | 65 | 15 | 900 | glatt | mäßig | 0,165 | OK | hoch |
| 35 | 1,6%/325 | 1,693 | 12,0 | 2190 | P-PC | 20 | 40 | 15 | 900 | uneben | hoch | 0,18-0,20 | OK | mäßig |
| 36 | 0,7%/325 | n.b.[+] | 11,9 | 2100 | P-CM-PC · | 20 | 50 | 15 | 900 | fehlerh./ rauh | hoch | 0,15-0,20 | niedrig | mäßig |

Anmerkungen zu Tabelle 2 siehe folgende Seite

0 262 565

Anmerkungen zu Tabelle 2

        a) Stahl-Typ
P = gebeizt
CO = nur gereinigt
CM = chemisch gewalzt
PC = gedruckte Schaltung
ELC = extrakohlenstoffarm
        b) geschätzter Erweichungspunkt
niedrig = ~825°C bis 875°C
mäßig = 875°C bis ~925°C
hoch = > 925°C
* = Schmelzpunkt sehr hoch
** = Zusammensetzung schmolz nicht vollständig
spez. Gewicht
+ n.b. = nicht bestimmt

## Ansprüche

1. Partiell entglaste Email-Zusammensetzung, erhältlich durch Schmelzen einer Mischung von Stoffen, die beim Schmelzen ein Oxid-Gemisch bilden, das im wesentlichen aus

(a)     20 bis 50 Gew.-% BaO
(b)     30 bis 60 Gew.-% $SiO_2$
(c)     2 bis 20 Gew.-% $TiO_2$
(d)     0 bis 16 Gew.-% $K_2O$
(e)     0 bis 4 Gew.-% $Na_2O$
(f)     0 bis 4 Gew.-% $Li_2O$
(g)     0 bis 10 Gew.-% $Al_2O_3$
(h)     0 bis 3 Gew.-% $B_2O_3$
(i)     0 bis 3 Gew.-% $As_2O_3$
(j)     0 bis 10 Gew.-% CaO
(k)     0 bis 3 Gew.-% $CeO_2$
(l)     0 bis 10 Gew.-% MgO
(m)     0 bis 3 Gew.-% $F_2$
(n)     0 bis 3 Gew.-% $N_2O_5$
(o)     0 bis 3 Gew.-% PbO
(p)     0 bis 3 Gew.-% $P_2O_5$
(q)     0 bis 3 Gew.-% $Sb_2O_3$
(r)     0 bis 3 Gew.-% $SnO_2$
(s)     0 bis 10 Gew.-% SrO
(t)     0 bis 7 Gew.-% ZnO
(u)     0 bis 10 Gew.-% $ZrO_2$ und
(v)     0 bis 3 Gew.-% $MoO_3$

besteht, wobei die Summe der Gewichts-Anteile 100 Gew.-% beträgt, zur Bildung einer homogenen Schmelze, Abschrecken der Schmelze zur Bildung einer Fritte und Brennen der Fritte.

2. Zusammensetzung nach Anspruch 1, dadurch gekennzeichnet, daß die geschmolzene Mischung

(a)     25 bis 45 Gew.-% BaO
(b)     35 bis 50 Gew.-% $SiO_2$ und
(c)     4 bis 10 Gew.-% $TiO_2$
enthält.

3. Zusammensetzung nach Anspruch 2, dadurch gekennzeichnet, daß die geschmolzene Mischung weiterhin

(d)     0 bis 12 Gew.-% $K_2O$
(g)     2 bis 8 Gew.-% $Al_2O_3$

11

(j)    0 bis 5 Gew.-% CaO

(l)    0 bis 5 Gew.-% MgO

(s)    0 bis 5 Gew.-% SrO

(t)    0 bis 5 Gew.-% ZnO und

(u)    0 bis 5 Gew.-% $ZrO_2$

enthält.

4. Zusammensetzung nach Anspruch 1, dadurch gekennzeichnet, daß in der Schmelze wenigstens zwei der Oxide ausgewählt aus $Li_2O$, $Na_2O$ und $K_2O$ vorhanden sind.

5. Zusammensetzung nach Anspruch 1, dadurch gekennzeichnet, daß die geschmolzene Mischung

(a)    33 Gew.-% BaO

(b)    37,6 Gew.-% $SiO_2$

(c)    7,0 Gew.-% $TiO_2$

(d)    13 Gew.-% $K_2O$

(e)    3,3 Gew.-% $Na_2O$

(g) 6,0 Gew.-% $Al_2O_3$

(i)    0,1 Gew.-% $As_2O_3$ und

(n)    1,25 Gew.-% $N_2O_5$

enthält.

6. Verwendung der partiell entglasten Emails gemäß einem der Ansprüche 1 bis 5 zur Herstellung von Leiterplatten.

## EINSCHLÄGIGE DOKUMENTE

EP 87113866.5

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | <u>GB - A - 2 092 123</u> (EISENWERKE <u>FRIED WITH DUKER GMBH AND CO.</u>)<br><br>* Zusammenfassung *<br><br>-- | 1,2 | C 03 C 8/00<br><br>C 03 C 10/00<br><br>H 05 K 1/03 |
| X | <u>US - A - 3 445 209</u> (ASUNMAA)<br><br>* Ansprüche 2-4 *<br><br>-- | 1,2 | |
| X | <u>GB - A - 1 374 605</u> (PILKINGTON <u>BROTHERS LIMITED</u>)<br><br>* Ansprüche 1,2,17,18; Seite 9, Tabelle II, Glas Nr. 21,22, 23,26 *<br><br>-- | 1 | |
| X | <u>DE - A1 - 2 802 223</u> (HOYA CORP.)<br><br>* Seite 4, Zeile 23 - Seite 6, Zeile 23 *<br><br>-- | 1,2,4 | |
| X | <u>DE - B - 1 000 574</u> (PITTSBURGH <u>PLATE GLASS COMPANY</u>)<br><br>* Ansprüche 1-3 *<br><br>---- | 1-4 | RECHERCHIERTE SACHGEBIETE (Int. Cl.4)<br><br>C 03 C<br><br>H 05 K |

Der vorliegende Recherchenbericht wurde für alle Patentansprüche erstellt.

| Recherchenort | Abschlußdatum der Recherche | Prüfer |
|---|---|---|
| WIEN | 15-12-1987 | HAUSWIRTH |